# EUROPÄISCHE PATENTSCHRIFT

(11) **EP 0 354 253 B1**
(45) Veröffentlichungstag und Bekanntmachung des Hinweises auf die Patenterteilung: **01.12.1993**
(21) Anmeldenummer: 88112907.6
(22) Anmeldetag: 08.08.1988
(51) Int. Cl.: H04Q 3/52, H03K 17/693

(54) **Breitbandsignal-Koppeleinrichtung**
Coupling device for broad-band signals
Dispositif de couplage pour signaux à large bande

(43) Veröffentlichungstag der Anmeldung: 14.02.1990
(73) Patentinhaber: SIEMENS AKTIENGESELLSCHAFT, 80333 München (DE)
(72) Erfinder: Trumpp, Gerhard, Dipl.-Ing., D-8039 Puchheim (DE); Wolkenhauer, Jan, Dipl.-Ing., D-8000 München 70 (DE)

(56) Entgegenhaltungen:
- EP-A- 0 249 837
- EP-A- 0 254 011
- US-A- 4 434 381

## Beschreibung

Moderne Entwicklungen der Fernmeldetechnik führen zu diensteintegrierenden Nachrichtenübertragungs- u. -vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei in den Vermittlungsstellen auch (vorzugsweise gemeinsame Steuereinrichtungen aufweisende) Schmalbandsignal-Koppeleinrichtungen und Breitbandsignal-Koppeleinrichtungen nebeneinander vorgesehen sein können (DE-C- 24 21 002).

Eine (z.B. aus EP-A- 0 249 837) bekannte Breitbandsignal-Koppeleinrichtung weist eine Koppelpunktmatrix in FET-Technik auf, an deren Eingängen jeweils eine Eingangstreiberschaltung vorgesehen sein kann,
deren Ausgänge jeweils mit einer Ausgangsverstärkerschaltung versehen sind,
in der die Koppelpunkte mit im Durchschaltezustand jeweils einen gegenüber dem an einem Matrixeingang wirksamen Innenwiderstand großen Durchlass- bzw. Innenwiderstand aufweisenden Koppelelementen gebildet sind
und deren Ausgangsverstärkerschaltungen jeweils eine in die betreffende Ausgangsleitung eingefügte Kettenschaltung eines invertierenden C-MOS-Inverters und eines Haltespeichers, vorzugsweise eines D-Kippgliedes, und einen zwischen Inverterausgang und Invertereingang liegenden **Schalter** mit gegenüber dem Widerstand eines Koppelelements kleinem Durchlaßwiderstand aufweisen, **dessen** Steuerelektrode - ggf. zusammen mit dem Takteingang des D-Kippgliedes - mit einem eine Bit-Durchschaltezeitspanne in eine Vorladephase und die eigentliche Durchschaltephase unterteilenden Vorladetakt beaufschlagt ist
**und über den** in jeder Vorladephase die betreffende Matrixausgangsleitung zumindest angenähert auf ein der Schaltschwelle des CMOS-Inverters entsprechendes Potential umgeladen wird, das etwa in der Mitte zwischen den an den beiden Anschlüssen der Betriebsspannungsquelle herrschenden Potentialen liegt; hiervon ausgehend wird in der nachfolgenden Durchschaltephase von der zugehörigen Matrixeingangsleitung her über das jeweils durchgeschaltete Koppelelement die zum Eingang des Inverters führende Matrixausgangsleitung auf das dem damit durchgeschalteten Bit entsprechende Potential in der einen oder in der anderen Richtung umgeladen.

Andere Breitbandsignal-Koppeleinrichtungen (s. z.B. EP-A-0262479) weisen eine Koppelpunktmatrix in FET-Technik auf,
deren Eingänge jeweils mit einer Eingangstreiberschaltung versehen sein können,
deren Ausgänge jeweils mit einer Ausgangsverstärkerschaltung versehen sein können und
deren jeweils von einer Halte-Speicherzelle gesteuerten Koppelelemente jeweils mit einer **Serienschaltung** eines an seiner Steuerelektrode mit einem Durchschalte- bzw. Sperrsignal beaufschlagten Schalter-Transistors und eines mit seiner Steuerelektrode an die zugehörige Matrixeingangsleitung angeschlossenen Eingangs-Transistors gebildet sind, **die** mit der der Serienschaltung abgewandten Hauptelektrode des einen Transistors an die zugehörige Matrixausgangsleitung angeschlossen ist, wobei die Matrixausgangsleitung mit dem einen Anschluß der Betriebsspannungsquelle über eine Vorladeschaltung verbunden ist, die mit einem Entriegelungseingang an die Taktsignalleitung eines die Vorladephase einer in eine solche Vorladephase und die übrige Bit-Durchschaltezeitspanne unterteilten Bit-Durchschaltezeitspanne definierenden Vorladetaktsignals angeschlossen ist, so daß die Matrixausgangsleitung in jeder Vorladephase zumindest angenähert auf das an dem einen Anschluss der Betriebsspannungsquelle herrschende Potential geladen wird; hiervon ausgehend wird in der nachfolgenden Durchschaltephase je nach dem dem durchzuschaltenden Bit entsprechenden, auf der betreffenden Matrixeingangsleitung herrschenden Signalzustand die mit dieser Matrixeingangsleitung über das betreffende Koppelelement verbundene Matrixausgangsleitung entladen werden oder auf dem in der Vorladephase angenommenen Betriebspotential verbleiben.

Will man in einer Breitbandsignal-Koppeleinrichtung der zuletzt genannten Art eine Ausgangsverstärkerschaltung der zuvor genannten Art vorsehen, so bringt dies hinsichtlich der von deren Inverter zu treffenden Entscheidung, ob das durchgeschaltete Bit ein "O"-Bit oder ein "l"-Bit ist, eine Entscheidungsunsicherheit mit sich, die auf einer verbleibenden Differenz zwischen Vorladepotential und Entscheidungsschwelle beruht.
Die Erfindung zeigt demgegenüber einen Weg zu einer erhöhten Entscheidungssicherheit.

Die Erfindung betrifft eine Breitbandsignal-Koppeleinrichtung mit einer Koppelpunktmatrix in FET-Technik, an deren Eingängen jeweils eine Eingangstreiberschaltung vorgesehen sein kann und deren Ausgänge jeweils mit einer Ausgangsverstärkerschaltung versehen sind, die eine in die betreffende Ausgangsleitung eingefügte Kettenschaltung eines C-MOS-Inverters und eines Haltespeichers (Latch) und einen den C-MOS-Inverter rückkoppelnden, vorladetaktgesteuerten **Schalter** aufweist, **dessen** Steuerelektrode mit einem eine Bit-Durchschaltezeitspanne in eine Vorladephase und die eigentliche Durchschaltephase unterteilenden Vorladetaktsignal beaufschlagt ist, **wobei** in jeder Vorladephase die betreffende Matrixausgangsleitung auf ein zwischen den beiden Betriebspotentialen liegendes Vorladepotential gelangt; diese Koppeleinrichtung ist erfindungsgemäß dadurch gekennzeichnet, daß dem den einen Inverterzweig bildenden Transistor die Serienschaltung eines mit seiner Steuerelektrode am Invertereingang liegenden weiteren Transistors gleichen Kanaltyps und eines gegensinnig zum Schalter vorladetaktgesteuerten weiteren Schalters parallelgeschaltet ist.

Die Erfindung, derzufolge die nach der Vorladephase wirksame Entscheidungsschwelle des Inverters im Vergleich zu der in der Vorladephase wirksamen Schaltschwelle nach Maßgabe der Bemessung der den einen Inverterzweig einschliessenden Parallelschaltung gegenläufig zum Vorladepotentialhub verlagert wird, bringt den Vorteil mit sich, die durch die Inverter-Schaltschwelle gegebene Entscheidungsschwelle derart bezüglich des Vorladepotentials zu verlagern, daß auch bei tendenzieller Übereinstimmung zwischen dem Vorladepotential und dem im Zuge der Signaldurchschaltung auf der Matrixausgangsleitung gerade aufzubauenden Potential die Schaltschwelle des Inverters deutlich überschritten (bzw. unterschritten) wird.

Es sei an dieser Stelle bemerkt, daß (aus der US-A- 4 434 381) ein Abtastverstärker mit einem C-MOS-Inverter und einem den C-MOS-Inverter rückkoppelnden, an seiner Steuerelektrode mit einem Vorladetaktsignal gesteuerten Schalter bekannt ist, bei dem dem den einen Inverterzweig bildenden Transistor die Serienschaltung eines mit seiner Steuerelektrode am Invertereingang liegenden weiteren Transistors gleichen Kanaltyps und einem gleichsinnig zum Schalter vorladetaktgesteuerten weiteren Schalters parallelgeschaltet ist. Diese gleichsinnig mit dem Schalter gesteuerte Parallelschaltung stellt sicher, daß in der Vorladephase der Widerstand des betreffenden Inverterzweigs (einschließlich der Parallelschaltung) gleich dem Widerstand des anderen Inverterzweigs ist; nach Beendigung der Vorladephase wird der Parallelzweig abgeschaltet mit der Folge, daß ein Ausgangsspannungsoffset von +0,5 V, das aus einem von einer besonderen Vorstromquelle bewirkten Eingangsvorspannungsoffset von -0,05 V resultiert, ohne Rückwirkung auf das Eingangspotential rückgeführt wird. Im "O"-Eingangssignalzustand, in dem kein nennenswerter Eingangsstrom fließt, bewirkt nun die Vorstromquelle, daß das Eingangspotential absinkt und das Ausgangspotential relativ schnell ansteigt; im "l"-Eingangssignalzustand fließt ein dem Vorstrom entgegengerichteter höherer Eingangsstrom, so daß das Eingangspotential steigt und das Ausgangspotential relativ schnell abfällt. Mit Hilfe der Vorstromquelle wird so bei dem bekannten Abtastverstärker Entscheidungssicherheit hinsichtlich des einzunehmenden Ausgangssignalzustands gewonnen; die Erfindung ermöglicht demgegenüber eine erhöhte Entscheidungssicherheit, ohne daß es einer besonderen Vorstromquelle bedarf.

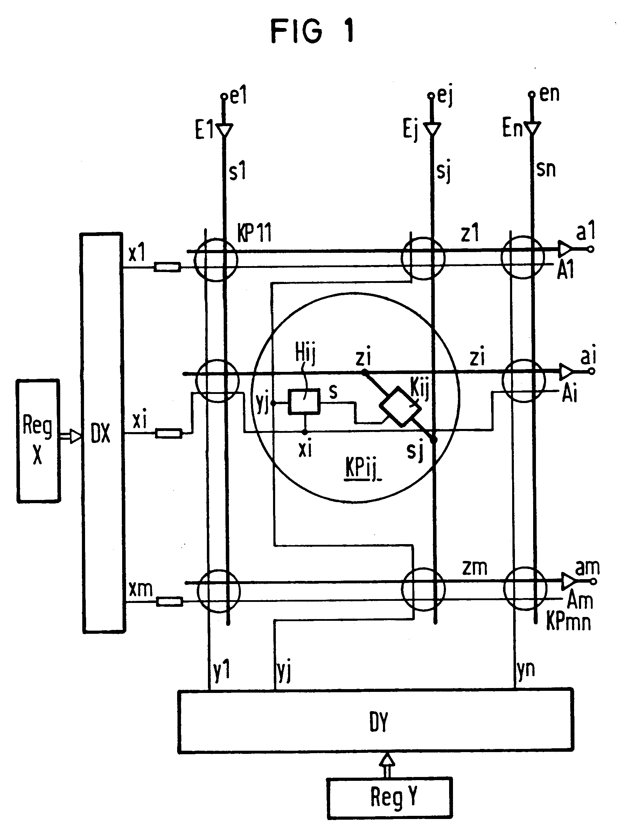

Weitere Besonderheiten der Erfindung werden aus der nachfolgenden näheren Erläuterung der Erfindung anhand der Zeichnung ersichtlich. Dabei zeigen
- FIG 1: das Schema einer Breitband-Koppeleinrichtung und
- FIG 2 bis FIG 6: Einzelheiten ihrer schaltungstechnischen Realisierung gemäß der Erfindung;
- FIG 7: verdeutlicht Signalzustände darin
In der Zeichnung FIG 1 ist schematisch in zum Verständnis der Erfindung erforderlichem Umfange eine Breitbandsignal-Koppeleinrichtung skizziert, an deren zu Spaltenleitungen sl...sj...sn einer Koppelpunktmatrix führenden Eingängen el...ej...en Eingangstreiberschaltungen El...Ej...En vorgesehen sind und deren von Zeilenleitungen zl...zi...zm der Koppelpunktmatrix erreichte Ausgänge al...ai...am mit Ausgangsverstärkerschaltungen Al...Ai...Am versehen sind.
Die Koppelpunktmatrix weist Koppelpunkte KPll...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert sein können, deren Ausgang s zum Steuereingang des jeweiligen Koppelelements (Kij beim Koppelpunkt KPij) führt.

Die Halte-Speicherzellen ... Hij... werden gemäß FIG 1 durch zwei Ansteuerdecoder, nämlich einen Zeilendecoder DX und einen Spaltendecoder DY, über entsprechende Ansteuerleitungen xl...xi...xm; yl...yj...yn in zwei Koordinaten angesteuert.

Dazu mögen, wie dies aus FIG 1 ersichtlich ist, die beiden Ansteuerdecoder DX, DY von Eingangsregistern Reg X, Reg Y her jeweils mit einer einer Matrixreihe (Zeile bzw.Spalte) von Koppelpunkten gemeinsamen Koppelpunktzeilen- bzw. Koppelpunktspalten-Adresse beaufschlagbar sein, auf die hin sie jeweils an der der jeweiligen Koppelpunktreihen-Adresse entsprechenden Ansteuerleitung jeweils ein "l"-Ansteuersignal abgeben. Das Zusammentreffen eines Zeilenansteuersignals "l" und eines Spaltenansteuersignals "l" am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "l" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "O" abgibt; das Zusammentreffen von Zeilenansteuersignal "l" und Spaltenansteuersignal "O" bewirkt dann die Rücksetzung der Halte-Speicherzelle Hij mit der Folge, daß das von ihr gesteuerte Koppelelement Kij gesperrt wird.

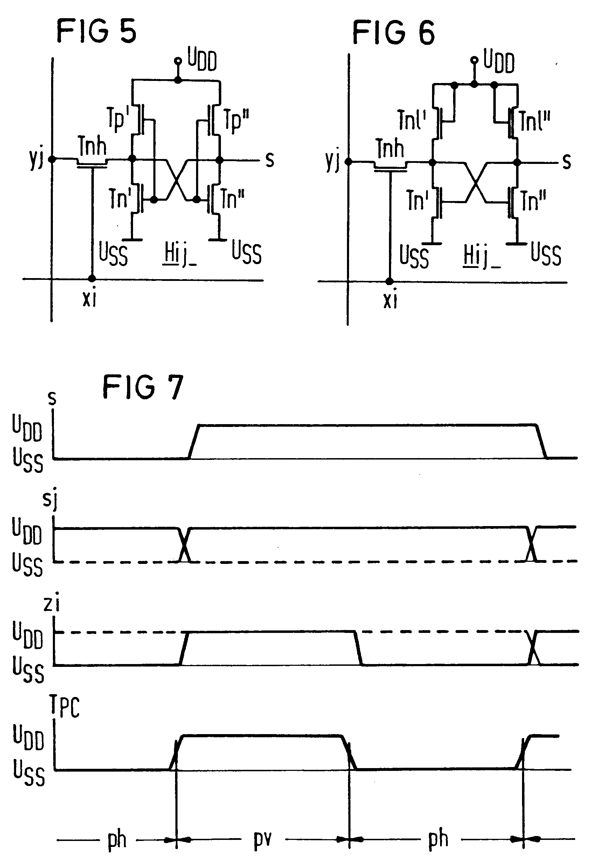

Die Halte-Speicherzellen ...Hij... können in an sich bekannter Weise ausgebildet sein; so können die Halte-Speicherzellen beispielsweise, wie dies z.B. aus EP-A-0 238 834 bekannt und auch in FIG 5 und FIG 6 skizziert ist, mit einem n-Kanal-Transistor Tnh und zwei kreuzgekoppelten Inverterschaltungen (C-MOS-Inverterschaltungen Tp′,Tn′; Tp˝,Tn˝ in FIG 5, n-MOS-Inverterschaltungen Tnl′,Tn′; Tnl˝,Tn˝ in FIG 6) gebildet sein, wobei eine Inverterschaltung eingangsseitig mit dem zugehörigen Decoderausgang yj des einen Ansteuerdecoders über den n-Kanal-Transistor Tnh verbunden ist, der seinerseits an seiner Steuerelektrode mit dem Ausgangssignal des zugehörigen Decoderausgangs xi des anderen Ansteuerdecoders beaufschlagt ist, und wobei eine Inverterschaltung ausgangsseitig zum Steuereingang s des zugehörigen Koppelelements führt.

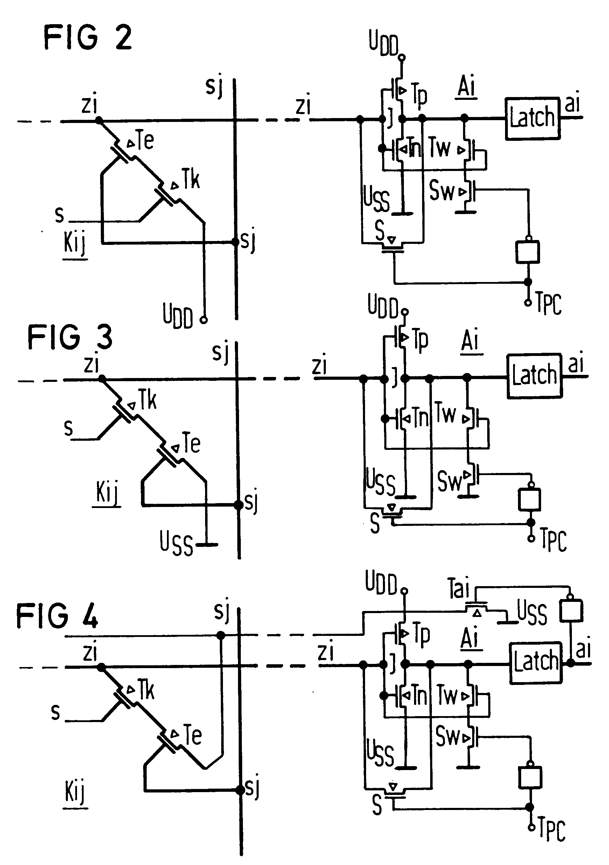

Wie die Koppelelemente ...Kij... schaltungstechnisch realisiert sein können, wird in FIG 2, FIG 3 und FIG 4 verdeutlicht: Die Koppelelemente ...Kij... sind jeweils mit einer **Serienschaltung** eines an seiner Steuerelektrode von der Halte-Speicherzelle her mit einem Durchschalte- bzw. Sperrsignal beaufschlagten Schalter-Transistors Tk und eines mit seiner Steuerelektrode an die zugehörige Matrixeingangsleitung sj angeschlossenen Eingangs-Transistors Te gebildet, **die** mit der der Serienschaltung abgewandten Hauptelektrode des einen Transistors Tk (in FIG 3 und FIG 4) oder Te (in FIG 2) an die zugehörige Matrixausgangsleitung zi angeschlossen ist; die der Serienschaltung abgewandte Hauptelektrode des anderen Transistors Te (in FIG 3 und FIG 4) bzw. Tk (in FIG 2) ist kontinuierlich mit einem Anschluß U_{SS}, Masse (in FIG 3 und FIG 4) bzw. U_{DD} (in FIG 2) der (z.B. 5-V-)Betriebsspannungsquelle verbunden, wozu bei unmittelbarer Verbindung gemäß FIG 2 und FIG 3 der entsprechende Betriebspotentialanschluß (U_{SS}, Masse bzw. U_{DD} in FIG 5 und FIG 6) der koppelpunktindividuellen Halte-Speicherzelle Hᵢⱼ (in FIG 1, FIG 5 und FIG 6) genutzt werden kann, so daß die ohnehin erforderliche Betriebsspannungsversorgung der koppelpunktindividuellen Halte-Speicherzelle für die Speisung des von dieser Halte-Speicherzelle gesteuerten Koppelelements mitausgenutzt wird. Im Ausführungsbeispiel gemäß FIG 4 ist die der Serienschaltung abgewandte Hauptelektrode des anderen Transistors (Te) über einen an seiner Steuerelektrode mit dem Ausgang ai einer matrixausgangsleitungs-individuellen Ausgangsverstärkerschaltung Ai verbundenen matrixausgangsleitungs-individuellen Transistor Tai mit dem betreffenden Anschluß U_{SS} der Betriebsspannungsquelle verbunden. Hierbei wird bei einer entsprechenden Signalzustandsänderung am Ausgang ai der Ausgangsverstärkerschaltung Ai der matrixausgangsleitungs-individuelle Transistor Tai gesperrt, so daß eine weitere Umladung der Ausgangsleitung vermieden wird und der Signalhub somit begrenzt wird.

Wie dies aus FIG 2 ersichtlich ist, kann die Transistor-Serienschaltung Tk-Te jedes Koppelelements Kij mit ihrem Eingangs-Transistor Te an der Matrixausgangsleitung zi liegen. Dabei ist der Eingangs-Transistor Te, von der Matrixausgangsleitung zi her gesehen, gewissermaßen transparent, so daß Signalzustandsänderungen auf der Matrixeingangsleitung sj über die Kanalkapazität des Eingangs-Transistors Te auch bei gesperrtem Koppelpunkt Kij auf die Matrixausgangsleitung zi durchgreifen. Dieser Durchgriff kann vermieden werden, wenn in der Transistor-Serienschaltung Tk-Te jedes Koppelelements Kij die Reihenfolge von Eingangs-Transistor Te und Schalter-Transistor Tk vertauscht ist: Wie dies auch aus FIG 3 und FIG 4 ersichtlich ist, liegt dann die Transistor-Serienschaltung Tk-Te jedes Koppelelements Kij mit ihrem Schalter-Transistor Tk an der Matrixausgangsleitung zi.

Die zwischen einer Matrixausgangsleitung zi (in FIG 1 bis FIG 4) und dem nachfolgenden Ausgang ai (in FIG 1 bis FIG 4) der Koppeleinrichtung vorgesehene Ausgangsverstärkerschaltung Ai (in FIG 1 bis FIG 4) weist nun, wie dies auch FIG 2 bis FIG 4 verdeutlichen, eine in die Ausgangsleitung zi-ai eingefügte Kettenschaltung eines mit zwei MOS-Transistoren Tp, Tn gebildeten C-MOS-Inverters J und eines Haltespeichers Latch sowie einen zwischen Inverterausgang und Invertereingang liegenden und damit den C-MOS-Inverter J rückkoppelnden, vorladetaktgesteuerten Schalter S auf. Der Schalter S kann, wie dies auch zeichnerisch dargestellt ist, als mit einem Feldeffekttransistor gebildetes Transfer-Gate ausgebildet sein; alternativ dazu ist es aber auch möglich, den Schalter als Transmission-Gate auszuführen. Die Steuerelektrode des Schalters S ist mit einem eine Bit-Durchschaltezeitspanne in eine Vorladephase pv (in FIG 7 unten) und die eigentliche Durchschaltephase (ph in FIG 7 unten) unterteilenden Vorladetaktsignal T_{PC} - ein geeignetes Vorladetaktsignal ist in FIG 7 in Zeile T_{PC} dargestellt - beaufschlagt, so daß der C-MOS-Inverter J jeweils während der Vorladephase pv in sich rückgekoppelt ist. Dabei gelangt die zum Invertereingang führende Matrixausgangsleitung zi zumindest angenähert auf ein der Schaltschwelle des Inverters J entsprechendes Potential von beispielsweise 2,5 V.

In der darauffolgenden Hauptphase ph (siehe FIG 7, unten), wird im Beispiel durch ein "LOW"-Vorladetaktsignal T_{PC} (siehe FIG 7, Zeile T_{PC}) der Rückkopplungsschalter S (in FIG 2 bis FIG 4) gesperrt. Ist nun in einem Koppelelement Kij dessen vorzugsweise durch einen n-Kanal-Transistor gegebener Schalt-Transistor Tk (in FIG 2 bis FIG 4) aufgrund eines am Steuereingang s anliegenden (im Beispiel "HIGH"-)Durchschaltesignals (siehe FIG 7, Zeile s) leitend und befindet sich damit der Koppelpunkt im Durchschaltezustand, so wird jetzt je nach dem dem durchzuschaltenden Bit entsprechenden, auf der betreffenden Matrixeingangsleitung (Spaltenleitung) ...sj... herrschenden Signalzustand die mit dieser Matrixeingangsleitung (Spaltenleitung) ... sj... über das betreffende Koppelelement Kij verbundene Matrixausgangsleitung (Zeilenleitung) zi entladen werden oder auf dem in der Vorladephase pv angenommenen Vorladepotential verbleiben:

Herrscht auf der betreffenden Matrixeingangsleitung (Spaltenleitung) sj der "HIGH"-Signalzustand, wie dies in FIG 7, Zeile sj, mit einer durchgezogenen Linie angedeutet ist, und ist dementsprechend der Eingangs-Transistor Te (in FIG 2 bis FIG 4) des betrachteten Koppelelements Kij ebenso wie der Schalter-Transistor Tk leitend, so wird die Matrixausgangsleitung (Zeilenleitung) zi über dieses Koppelelement Kij in Richtung auf das entsprechende Betriebspotential (U_{DD} im Ausführungsbeispiel gemäß FIG 2; U_{SS} in den Ausführungsbeispielen gemäß FIG 3 und FIG 4) hin entladen werden, so daß sie auf ein Potential von beispielsweise 2 V gelangt. Dies hat am Inverterausgang einen eindeutigen Übergang in den HIGH-Signalzustand zur Folge, der dann am Ende der Durchschaltephase vom nachfolgenden Haltespeicher (Latch) übernommen wird und damit am zugehörigen Ausgang ai der Koppeleinrichtung gegeben ist.

Herrscht dagegen auf der gerade betrachteten Matrixeingangsleitung (Spaltenleitung) sj der "LOW"-Signalzustand, wie dies in FIG 7, Zeile sj, mit einer gestrichelten Linie angedeutet ist, und ist dementsprechend der (n-Kanal-)Eingangs-Transistor Te (in FIG 2 bis FIG 4) des betreffenden Koppelelements Kij gesperrt, so wird die betreffende Matrixausgangsleitung (Zeilenleitung) zi über dieses Koppelelement Kij nicht entladen, sondern behält unter der Voraussetzung, daß kein anderer zu dieser Matrixausgangsleitung (Zeilenleitung) zi führender Koppelpunkt sich im Durchschaltezustand befindet, den Vorlade-Potentialzustand im wesentlichen bei, wobei an sich der verbleibende Abstand von Vorladepotential und Schaltschwelle den Inverter J an einer richtigen Entscheidung über den einzunehmenden Betriebszustand hindern würde. Um dem zu begegnen, ist dem den einen Inverterzweig bildenden Transistor Tn die Serienschaltung eines mit seiner Steuerelektrode am Invertereingang zi liegenden weiteren Transistors Tw gleichen Kanaltyps und eines gegensinnig zum Schalter S vorladetaktgesteuerten weiteren Schalters Sw parallelgeschaltet. Der weitere Schalter kann, wie dies auch zeichnerisch dargestellt ist, als mit einem Feldeffekttransistor gebildetes Transfer-Gate ausgebildet sein; alternativ ist es aber auch möglich, den weiteren Schalter als Transmission-Glied auszubilden. Wie dies aus FIG 2 bis FIG 4 ersichtlich wird, kann der weitere Schalter Sw an seiner Steuerelektrode mit dem in einem NICHT-Glied invertierten Vorladetaktsignal beaufschlagt sein.
Nach der Vorladephase pv (in FIG 7 unten), d.h. in der Durchschaltephase (ph in FIG 7), wird dann der eine Inverterzweig durch die Parallelschaltung zweier Transistoren gebildet und weist damit einen niedrigeren Widerstand auf als der nach wie vor mit nur einem Transistor gebildete andere Inverterzweig mit der Folge, daß die Schaltschwelle des Inverters J in der Durchschaltephase (Entscheidungsphase) von ihrer in der Vorladephase (im Beispiel bei einem Potential von 2,5 V) gegebenen Position weg in Richtung auf den komplementären Durchschaltesignalzustand hin verlagert wird, beispielsweise auf ein Potential von 2,2 V. Dies hat auch dann, wenn nach Maßgabe eines damit gerade durchgeschalteten Bits keine (weitere) Aufladung der Matrixausgangsleitung zi bewirkt wird, mit entsprechender Sicherheit den zugehörigen LOW-Signalzustand am Inverterausgang zur Folge, der dann am Ende der Durchschaltephase vom nachfolgenden Haltespeicher (Latch) übernommen wird und damit am zugehörigen Ausgang ai der Koppeleinrichtung gegeben ist.

Die Differenz zwischen der in der Vorladephase pv wirksamen Schaltschwelle und der in der Entscheidungsphase wirksamen Schaltschwelle und damit der für eine ausreichende Entscheidungssicherheit erforderliche Signalhub auf der Matrixausgangsleitung zi können durch entsprechende Dimensionierung der Inverter-Transistoren Tp, Tn und des weiteren Transistors Tw einschließlich des weiteren Schalters Sw eingestellt werden.

## Patentansprüche

1. Breitbandsignal-Koppeleinrichtung mit einer Koppelpunktmatrix in FET-Technik, an deren Eingängen (ej-sj) jeweils eine Eingangstreiberschaltung (Ej) vorgesehen sein kann und deren Ausgänge (zi-ai) jeweils mit einer Ausgangsverstärkerschaltung (Ai) versehen sind, die eine in die betreffende Ausgangsleitung (zi-ai) eingefügte Kettenschaltung eines C-MOS-Inverters (J) und eines Haltespeichers (Latch) und einen den C-MOS-Inverter (J) rückkoppelnden, vorladetaktgesteuerten **Schalter** (S) aufweist,
**dessen** Steuerelektrode mit einem eine Bit-Durchschaltezeitspanne in eine Vorladephase (pv) und die eigentliche Durchschaltephase (ph) unterteilenden Vorladetaktsignal (T_{PC}) beaufschlagt ist,
**wobei** in jeder Vorladephase (pv) die betreffende Matrixausgangsleitung (zi) auf ein zwischen den beiden Betriebspotentialen (U_{DD}, U_{SS}) liegendes Vorladepotential gelangt,
**dadurch gekennzeichnet**,
daß dem den einen Inverterzweig bildenden Transistor (Tn) die Serienschaltung eines mit seiner Steuerelektrode am Invertereingang liegenden weiteren Transistors (Tw) gleichen Kanaltyps und eines gegensinnig zum Schalter (S) vorladetaktgesteuerten weiteren Schalters (Sw) parallelgeschaltet ist.

2. Breitbandsignal-Koppeleinrichtung nach Anspruch 1,
**dadurch gekennzeichnet**,
daß die Schalter (S, Sw) als Transfer-Gates ausgebildet sind.

3. Breitbandsignal-Koppeleinrichtung nach Anspruch 1,
**dadurch gekennzeichnet**,
daß die Schalter als Transmission-Gates ausgebildet sind.

## Claims

1. Broadband signal switching network having a crosspoint matrix in FET technology, at the inputs (ej-sj) of which an input driver circuit (Ej) can be provided in each case and the outputs (zi-ai) of which are each provided with an output amplifier circuit (Ai) which has a chain circuit, inserted into the respective output line (zi-ai), of a C-MOS inverter (J) and a holding memory (Latch), and a pre-charging clock-controlled switch (S) feeding back the C-MOS inverter (J), the control electrode of which switch (S) receives a pre-charging clock signal (T_{PC}) that subdivides a bit through-connection time period into a pre-charging phase (pv) and the actual through-connection phase (ph), in which the respective matrix output line (zi) reaches a pre-charging potential lying between the two operating potentials (U_{DD}, U_{SS}) in every pre-charging phase (pv), characterized in that the transistor (Tn) forming the one inverter branch is connected in parallel with the series circuit of a further transistor (Tw) of the same channel type connected by its control electrode to the inverter input and a further switch (Sw) which is pre-charging clock-controlled in opposition to the switch (S).

2. Broadband signal switching network according to Claim 1, characterized in that the switches (S, Sw) are designed as transfer gates.

3. Broadband signal switching network according to Claim 1, characterized in that the switches are designed as transmission gates.

## Revendications

1. Dispositif de couplage de signaux à large bande comportant une matrice de points de couplage en technique FET, aux entrées (ej-sj) duquel peut être prévu respectivement un circuit d'attaque d'entrée (Ej) et dont les sorties (zi-ai) sont munies respectivement d'un circuit amplificateur de sortie (Ai) qui comporte un circuit chaîne qui est inséré dans la ligne de sortie (zi-ai) concernée et qui est constitué d'un inverseur C-MOS (J) et d'une mémoire de maintien (Latch), et un commutateur (S) contre-réactionnant l'inverseur C-MOS (J) et commandé par charge d'horloge, dont l'électrode de commande est chargée par un signal de charge d'horloge (T_{PC}) séparant un intervalle de temps de passage d'un bit en une phase de charge (pv) et en la phase propre de passage (ph), du type dans lequel dans chaque phase de charge (pv), la ligne de sortie de la matrice concernée (zi) atteint un potentiel de charge situé entre les deux potentiels de service (U_{DD}, U_{SS}),
caractérisé en ce que parallèlement au transistor (Tn) formant l'une des branches de l'inverseur, est branché le circuit série constitué d'un autre transistor (Tw) de même type de canal et placé, par son électrode de commande, à l'entrée de l'inverseur, et d'un autre commutateur (Sw) commandé par charge d'horloge dans le sens opposé au commutateur (S).

2. Dispositif de couplage de signaux à large bande suivant la revendication 1,
caractérisé en ce que les commutateurs (S, Sw) sont réalisés comme grille de transfert.

3. Dispositif de couplage de signaux à large bande suivant la revendication 1,
caractérisé en ce que les commutateurs sont réalisés comme portes de transmission.
